Europäisches Patentamt

European Patent Office

Office européen des brevets

(11) Publication number: **0 217 774**
**A1**

# EUROPEAN PATENT APPLICATION

(21) Application number: **86850322.8**

(22) Date of filing: **22.09.86**

(51) Int. Cl.⁴: **G 01 R 31/02**
**F 02 M 65/00**

(30) Priority: **03.10.85 SE 8504586**

(43) Date of publication of application:
**08.04.87 Bulletin 87/15**

(84) Designated Contracting States:
**BE DE FR GB IT NL SE**

(71) Applicant: **AB VOLVO**
**Torslanda**
**S-405 08 Göteborg(SE)**

(72) Inventor: **Johansson, Rolf**
**Skomakarevägen 10**
**S-51010 Horred(SE)**

(74) Representative: **Hellbom, Lars Olof et al,**
**H. Albihns Patentbyra AB Box 7664**
**S-103 94 Stockholm(SE)**

(54) **Method for fault-finding in electronic control systems in motor vehicles and device for carrying out said method.**

(57) The invention relates to a method of fault-finding in electronic control systems in automobiles and is characterized in that an adapter (11) is coupled between the control system (6) and its ordinary connector member (9), whereafter a measuring instrument (1) is connected to a measuring outlet (14) on the adapter.

EP 0 217 774 A1

Method for fault-finding in electronic control systems
in motor vehicles and device for carrying out said
method

In electronic control systems, which control
for example an electronic fuel injection system in
motor vehicles, the electronic components are usually
consolidated in a module, having a plurality of pin
contacts which, via a contact member with a cable, are
connected to the electronically controlled system(s).

For fault-finding, a measuring instrument is
connected to the electronics unit. Up to now, this has
been done by coupling the contact members of the
measuring instrument directly to one or more of the
pin contacts of the electronics unit.

According to the present invention an adapter
is used instead, which is coupled between the electronics module and the ordinary contact member. The
adapter has a contact portion which corresponds to the
ordinary contact member, a contact portion corresponding to the contacts of the electronics module and a
measuring outlet adapted to the contact member of the
measuring instrument for coupling in the same.

Various contacts or combinations of contacts in
the electronics module are represented in the measuring
outlet. The measuring instrument, depending on its
setting, takes measurements from one or more of the
measuring outlet pins and provides a reading on a
gauge. The contacts of the measuring outlet are coupled
to the adapter contacts connectable to the electronic
control unit in a unique manner for each vehicle model.

This means that a single measuring instrument
can be used for a number of different vehicle models,
there being an automatic adaption when connecting the
adapter designed for the model in question. There are
special instructions for each vehicle model for
evaluating the instrument readings.

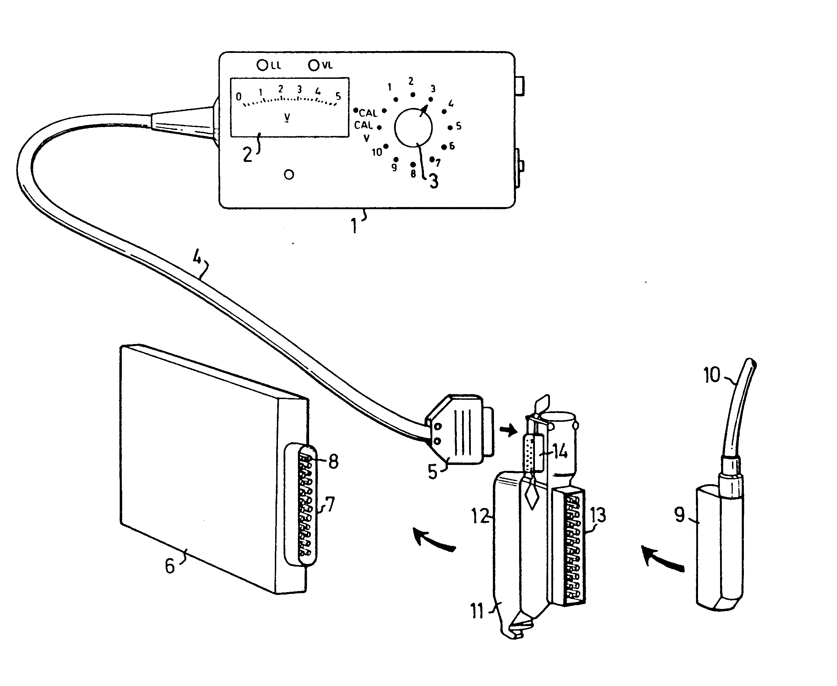

The invention is illustrated in more detail in the accompanying drawing, which shows schematically the component uncoupled from each other.

In the Figure, 1 designates a measuring instrument with a gauge 2 in the form of an analog voltmeter and a selector knob 3 for selecting the measurement function. The instrument 1 is connected to a cable 4, which is joined to a multipole female contact 5.

An electronic control system in the form of an electronics module 6 has a male contact 7 with a number of pins 8 and is normally connected to a connector member 9 with a female contact adapted to the male contact 7. The connector member 9 has a cable 10 which leads to the system controlled by the electronics unit, e.g. a fuel injection system.

When the control system is to be tested, the module 6 is separated from the connector member 9 and an adapter 11 is coupled in between them. The adapter 11 has a female contact 12 adapted to the contact 7 of the module 6 and a male contact 13 adapted to the connector member 9. The contact 5 of the measuring instrument is connected to a contact 14 which serves as a measuring outlet from the adapter. The contact pins of the measuring outlet are electrically connected to the pins of the adapter contact 12 in a manner particular to each vehicle model, so that a single measuring instrument can be used for a number of different vehicle models, by connecting different adapters.

CLAIMS

1. Method of fault-finding in electronic control systems in motor vehicles, e.g. in control systems for fuel injection systems, whereby a measuring instrument is connected to contact members on an electronics module included in the control system, characterized in that an adapter with contact members adapted to the contact members of the electronics module is connected to the electronics module and that the measuring instrument is connected to a measuring outlet on the adapter.

2. Equipment for fault-finding in electronic control systems in motor vehicles, e.g. in control systems for fuel injection systems, comprising an electronic measuring instrument, characterized by an adapter (11) with contact members (12) adapted to contact members (7) on an electronics module (6) included in the control system and with a measuring outlet (14) with contact members adapted to a contact member (5) connected to the measuring instrument.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | BOSCH, Tekniska Nyheter, AUTO 81, BOSCH-MOTRONIC 1981, p.1-6, especially p.6 and the left halves of elements 1 and 2, which halves can be seen as one unit<br><br>- - - | 1-2 | G 01 R 31/02<br>F 02 M 65/00 |

**TECHNICAL FIELDS SEARCHED (Int. Cl.4)**

G 01 R
F 02 M

The present search report has been drawn up for all claims

| Place of search | Date of completion of the search | Examiner |
|---|---|---|
| STOCKHOLM | 11-11-1986 | WIRLEE S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82